# EUROPEAN PATENT APPLICATION

(11) **EP 1 199 807 A1**
(43) Date of publication of application: **24.04.2002**
(21) Application number: 01124460.5
(22) Date of filing: 11.10.2001
(51) Int. Cl.: H03L 7/095

(54) **Out-of-sync detector, receiver and optical receiver**

(30) Priority: 16.10.2000 JP 2000315367
(71) Applicant: NEC CORPORATION, Tokyo (JP)
(72) Inventor: Noguti, Hidemi, Minato-ku, Tokyo (JP)
(74) Representative: Glawe, Delfs, Moll & Partner

(57) **Abstract**

The circuit includes a delay circuit 1 for phase-delaying clocks output from a voltage controlled oscillator by a predetermined phase, a flip flop 2 for capturing the clock delayed by the delay circuit at a falling edge or rising edge of the data signal, an average value circuit 3 for detecting a time average value of an output of the flip flop, and a comparator 4 for comparing in amplitude the time average value with a predetermined fixed value and then issuing an alarm when out-of-sync of a clock is detected.

## Description

### BACKGROUND OF THE INVENTION

The present invention relates to an out-of-clock synchronization (sync) detector. Particularly, the present invention relates to a circuit suitable for detecting phase shifts in clock synchronization for, for example, optical receivers.

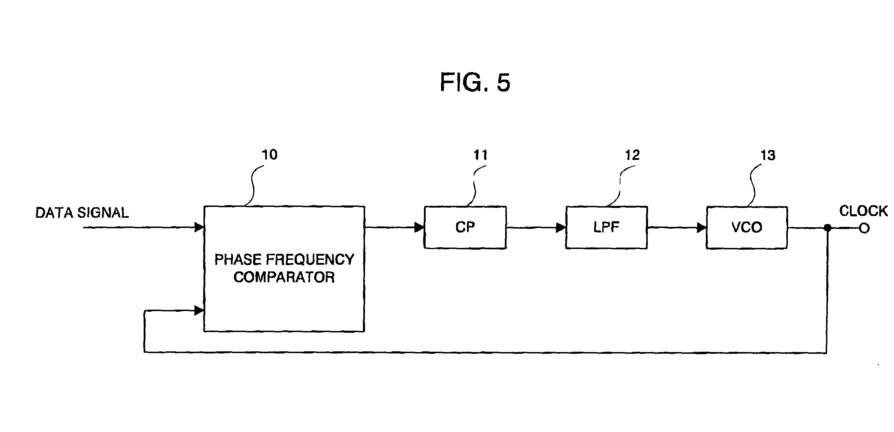

In optical receivers, an opto-electrical converter (e.g. a photo diode) receives a photo signal, converts the signal into a current, and amplifies and then converts it into a voltage. A PLL (Phase Locked Loop) receives received data as a signal with a logical amplitude and then creates a signal (clock) synchronized with the received data. The PLL, as shown in Fig. 5, typically includes a phase frequency comparator 10 that receives a received data signal, a charge pump (CP) 11 that charges or discharges a capacitance corresponding to a difference in frequency and phase detected by the phase frequency comparator 10 and creates a voltage corresponding to a phase difference, a loop filter (LPF) 12 that smoothes and outputs a voltage corresponding to a difference in frequency and in phase, and a voltage controlled oscillator (VCO) 13 that receives as a control signal an output from the loop filter 12 and varies its oscillation frequency in accordance with the control signal. The oscillation output clock of the voltage controlled oscillator (VCO) 13 is fed back to the phase frequency comparator 10. The phase frequency comparator 10 detects a difference in frequency and phase between a received data signal and an output clock of the voltage controlled oscillator 13 and supplies a control signal corresponding to the frequency and phase difference to the voltage controlled oscillator (VCO) 13. Thus, the voltage controlled oscillator 13 creates clocks in sync with the data signal. When the output clock of the voltage controlled oscillator (VCO) 13 has a multiplied frequency of the frequency of the data signal, the signal, which is obtained by dividing the output signal (reproduction clock) of the voltage controlled oscillator (VCO) 13 by a frequency divider, is fed back to the phase frequency comparator 10.

In the optical receiver, the function of detecting deterioration of the S/N (signal to noise) ratio of a received data signal transmitted on a transmission line and issuing the alarm is necessary to maintain the quality of the transmission line.

A conventional S/N ratio deterioration detection configuration uses the frequency control signal of the voltage controlled oscillator (that is, a control voltage input from the loop filter 12 to the voltage controlled oscillator 13 in the PLL shown in Fig. 5). By monitoring the value of the frequency control signal, it is well known that the alarm is issued when the frequency control signal value is largely stepped out from a locked state. That is, when the PLL is largely stepped out from a locked state, the frequency control signal changes. When the change exceeds a predetermined threshold value, the alarm is issued.

However, in the conventional apparatus that detects out-of-synchronization with the frequency control signal of the voltage controlled oscillator, deterioration of the S/N ratio of a data signal increases the jitter of the data signal. For that reason, the frequency control signal is largely varied to bring the voltage controlled oscillator into a locked state. In other words, when the jitter of the data signal increases, the frequency varies near to the original frequency of a data signal bit by bit (every clock bit) (that is, the transition point of the data signal varies). Thus, the data value has a random pattern (noises) in which 1s or 0s are randomly distributed. As a result, the frequency control signal is largely varied so as to pull the voltage controlled oscillator in a locked state. For that reason, because of the presence of the jitter components, it becomes difficult to set a threshold value distinguishing between a normal state (a synchronized state) and an alarm state with the value of a frequency control signal supplied to the voltage controlled oscillator.

Even when a predetermined transmission line quality is maintained, the data signal transmitted to the transmission line actually has somewhat jitters. In such a case, the frequency control signal varies so as to bring the voltage controlled oscillator into a locked state.

In the above configuration that performs alarm decision using the frequency control signal of the voltage controlled oscillator, because a small jitter component existing in a data signal varied the frequency control signal, it become difficult to set the threshold value distinguishing between a normal state and an alarm state. Hence, it is difficult to perform the control under which no alarm is issued at a normal state and which the alarm is certainly issued at the time of large deterioration of the S/N ratio.

### SUMMARY OF THE INVENTION

The present invention is made to solve the above-mentioned problems.

An object of the present invention is to provide an out-of-sync detector that can certainly produce the alarm in out-of-frequency synchronization or in a largely deteriorated S/N ratio of a received data signal, without issuing the alarm at normal time.

Another object of the present invention is to provide a receiver and an optical receiver including the out-of-sync detector.

In order to achieve the object of the present invention, an out-of-sync detector comprises a first circuit for delaying one of the two signals by a predetermined phase and outputting a delayed signal; a second circuit for sampling outputs of the first circuit in sync with a transition of the other of the two signals; a third circuit for outputting an average value of an output from the second circuit; and a fourth circuit for comparing the average value with a predetermined threshold value and detecting the presence or absence of out-of-synchronization.

Furthermore, according to the present invention, an out-of-sync detector, which receives a first signal and a second signal of which the phase and frequency are synchronized with those of the first signal and detects whether or not the first signal is synchronized with the second signal, comprises a delay circuit for delaying the second signal by a predetermined phase; a sequential logical circuit for sampling the second signal delayed by the delay circuit, in sync with a falling or rising transition of the second signal; an average value detector for detecting an average value of an output of the sequential logical circuit; and a comparator for comparing in amplitude the average value from the average value detector with a predetermined threshold value and then outputting a comparison result as a signal indicating the presence or absence of out-of-synchronization.

In the out-of-sync detector according to the present invention, the second signal comprises an oscillation output signal of a signal oscillator. The signal oscillator receives a control signal having a value corresponding to a difference in phase between the first signal and the second signal and varies its oscillation frequency under the control signal.

### BRIEF DESCRIPTION OF THE DRAWING

This and other objects, features and advantages of the present invention will become more apparent upon a reading of the following detailed description and drawings, in which:
Fig. 1 is a diagram illustrating the configuration of an embodiment of the present invention;
Fig. 2 is a diagram explaining a timing operation at the time of frequency synchronization, in the embodiment of the present invention;
Fig. 3 is a diagram explaining a timing operation at the time of out-of-frequency synchronization, in the embodiment of the present invention;
Fig. 4 is a diagram explaining a timing operation in large jitter, in the embodiment of the present invention;
Fig. 5 is a diagram illustrating the configuration of a conventional PLL.

### DESCRIPTION OF THE EMBODIMENTS

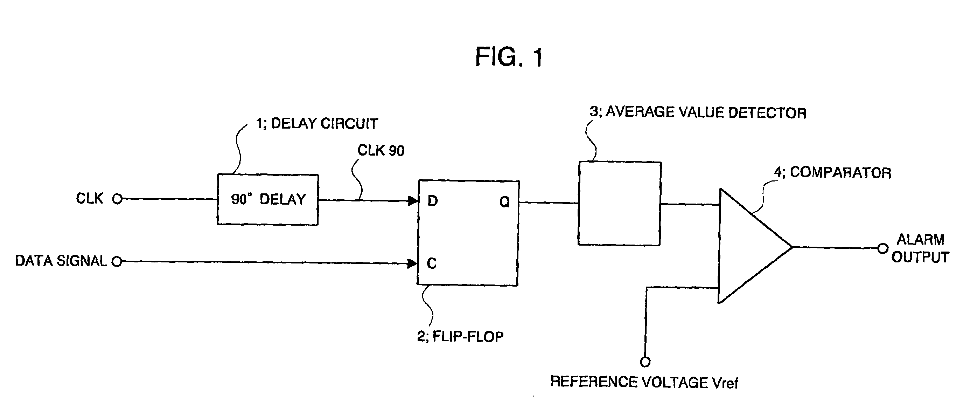

An embodiment of the present invention will be described here. Referring to Fig. 1, a preferred embodiment relates to a detector that receives a first signal (a data signal) and a second signal (CLK) of which the frequency and phase are synchronized with those of the first signal, and detects whether or not two signals are synchronized with each other. The detector includes a delay circuit (1) that delays the second signal (CLK) by a predetermined phase, a sequential logical circuit (2) that samples the value of the second signal (CLK 90) delayed by the delay circuit (1) in sync with a falling or rising transition of the first signal, an average value detector (3) that outputs an average value of an output from the sequential logical circuit (2), and a comparator (4) that compares an average value output from the average value detector (3) with a predetermined threshold value (Vref) to detect the presence or absence of out-of-synchronization and produces the alarm in the case of out-of-synchronization.

The second signal (CLK) corresponds to the oscillation output signal of the voltage controlled oscillator (see numeral 13 in Fig. 5). The voltage controlled oscillator 13 varies its output oscillation frequency in response to the control signal which has a value corresponding to a difference in frequency and in phase between the first signal (a data signal) and the second signal (CLK).

The delay circuit (1) delays the second signal (CLK) by a phase amount corresponding to a half of the pulse width of the second signal (CLK).

The sequential logical circuit (2) is a D-type flip-flop that samples (captures) the signal (CLK 90) in accordance with a positive or negative edge of the data signal acting as a trigger. The signal (CLK) is obtained by delaying an input signal, or the output of the voltage controlled oscillator, by means of the delay circuit (1). When the jitter width of the data signal is within the pulse width of the delay signal CLK 90 (or the width of a high level), the sequential logical circuit (2) outputs a high level (similar to that in synchronization). Hence, the comparator (4) does not produce the alarm. That is, even when jitter exists in the data, erroneous operation can be avoided if the jitter remains within a predetermined range.

In this embodiment, preferably, the delay circuit (1) delays by a phase amount of a half (corresponding to an intermediate value) of the pulse width of the second signal (CLK) pulse (or 1/4, or 90 degrees, in the case of a clock of a duty of 50).

The above-mentioned embodiment will be explained below in more detail. Fig. 1 is a diagram illustrating the configuration of an embodiment of the present invention. Referring to Fig. 1, the out-of-clock sync detector includes a delay circuit 1, a flip-flop 2, an average value detector 3, and a comparator 4. The delay circuit 1 receives a clock (CLK) from the voltage controlled oscillator that creates clocks in sync with the data signal (refer to numeral 13 shown in Fig. 5. In this case, a current controlled oscillator may be used) and delays its phase by 90 degrees. The flip-flop 2 receives the output (CLK) 90 of the delay circuit 1 at the data terminal D and receives a data signal (corresponding to a data signal input to the phase frequency comparator 10 shown in Fig. 5) at the clock terminal C. The above-mentioned data signal is obtained when an opto-electrical converter (not shown) converts an optical signal into an electrical signal and then amplifies it up to a logical level. The average value detector 3 detects an average value in time of output signals from the output terminal Q of the flip-flop 2. The comparator 4 compares the output of the average value detector 3 with the reference voltage Vref previously set and then issues the alarm. As explained later, with the clock (CLK) falling at transition of a data signal, the comparator 4 produces the alarm when the output of the average value detector 3 is less than the reference voltage Vref being a threshold value for alarm issuance. The flip-flop 2 is an edgetriggered flip-flop (called a D-type flip-flop) that samples the signal (the delay clock CLK 90) input to the data terminal D at the positive or negative edge of the signal (the data signal) input to the clock terminal C.

In order to detect an average in time of outputs from the flip-flop 2, the average value detector 3 converts the high-level time duration (a time width) of an output signal at the output terminal Q of the flip-flop 2 into a dc voltage level (a voltage between a low level and a high level). For example, the average value detector 3 may be a low-pass filter formed of a CR circuit having a time constant of a predetermined length. Moreover, the average value detector 3 may be a charge pump circuit that outputs, as an average value in time, the terminal voltage of the capacitance at the time a predetermined duration has passed. The charge pump has the configuration of charging a capacitance with a constant current during a high level of the output signal from the output terminal Q of the flip-flop 2.

The comparator 4 may have a hysteresis characteristic to suppress variations of the alarm output near to the threshold value determining an issuance of alarm. The comparator 4 has as threshold values reference values of V1 and V2 (V1 > V2). The comparator 4 may have the following configuration. That is, even when the output of the average value detector 3 is the reference value V1 or less (the status is regarded as normal when the output again exceeds V1 without dropping to V2 or less). the alarm is not issued immediately. When the output of the average value detector 3 becomes the reference value V2 or less, the alarm is issued. When the output again exceeds the reference value V2 and is V1 or more, alarming is stopped.

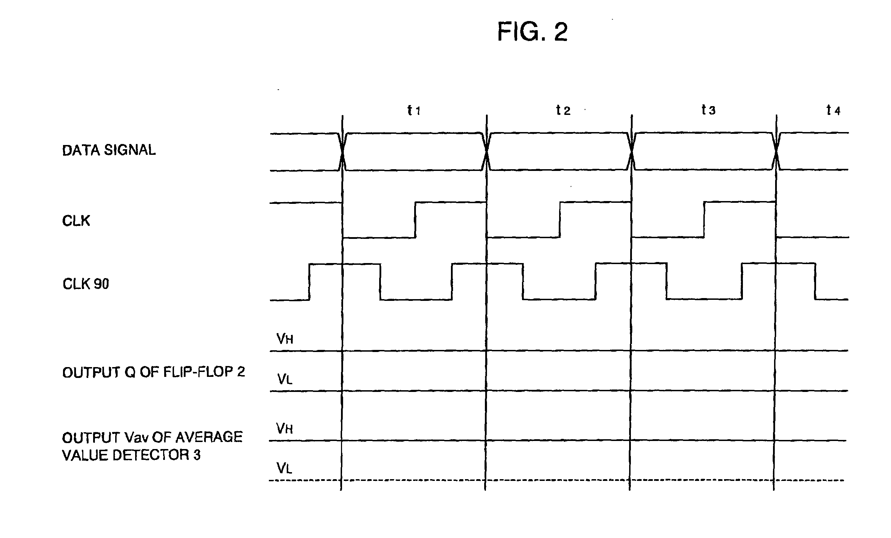

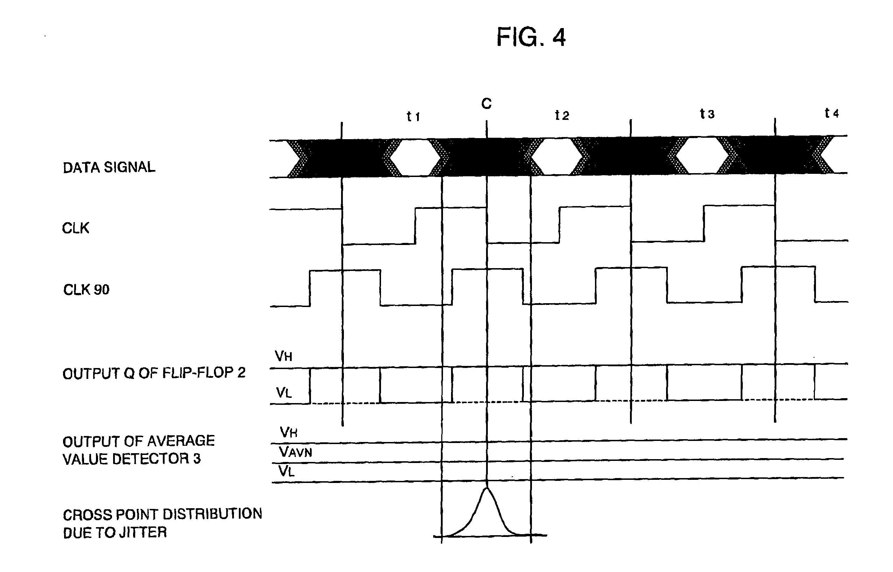

Next, the operation of the embodiment according to the present invention will be described below by referring to the timing charts of Figs. 2 and 4.

Fig. 2 is a diagram illustrating the operation at a normal time or at a frequency synchronization time, in the embodiment of the present invention. Referring to Fig. 2, CLK represents clocks from a voltage controlled oscillator that creates clocks synchronized with data signals. The CLK 90 represents clocks of which the phase of each clock CLK is delayed by 90 degrees using the delay circuit 1.

At the time of frequency synchronization, the falling of the clock CLK (the timing during which the status changes from a high level to a low level) always matches the cross point of a data signal.

The flip-flop 2 samples the high level VH of the CLK 90 input to the data terminal D, with the rising edge (or falling edge) of a data signal input to the clock terminal of the flip-flop 2 acting as a trigger. Hence, the output terminal Q of the flip-flop 2 always becomes a high level VH.

Hence, the output Vav of the average value detector 3, which obtains an average in time of outputs of the flip-flop 2, becomes a high level VH.

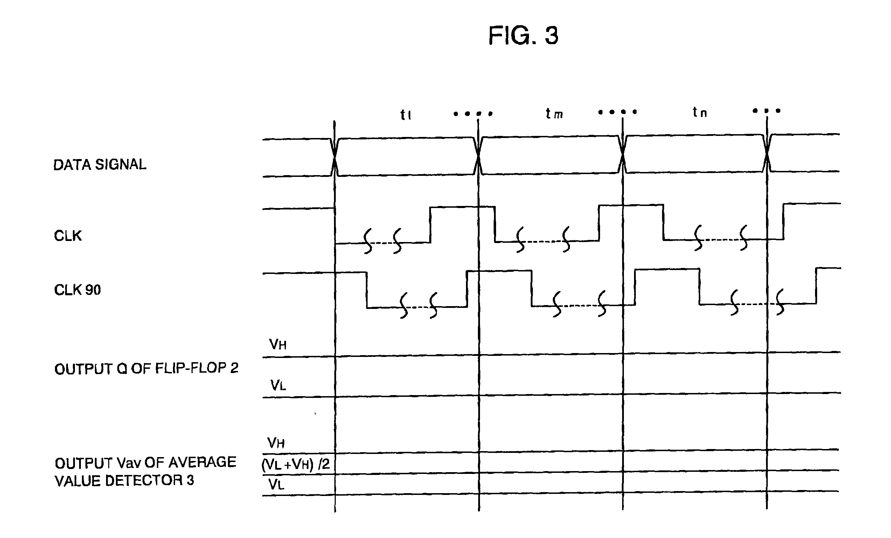

Fig. 3 is a diagram illustrating the timing operation at the time of out-of-synchronization, according to an embodiment of the present invention. When the frequency of the data signal is not synchronized with the frequency of the clock signal CLK from the voltage controlled oscillator, the timing at which the flip-flop 2 captures the clock signal CLK 90 at a transition edge of the data signal shifts every time (every cycle). That is, while the clock signal CLK at a high level is being sampled (cycles t1 to tm (where m > 1) shown in Fig. 3), the output Q of the flip-flop 2 is in a high level. However, at the cycle tn (where n>m) and the successive cycle t, the clock signal CLK 90 is in a low level VL during a transition of the data signal and the output Q of the flip-flop 2 is in a low level VL. When the flip-flop 2 outputs a chain of high level signals VH for continuous several cycles and a chain of low level signals VL for continuous several cycles, alternately. The frequency is equal to the frequency corresponding to a shift between the frequency of the data signal and the frequency of the clock CLK.

For that reason, the average value Vac becomes (VH+VL)/2 because the appearance frequency of the high level VH is equal to the appearance frequency of the low level VL. The average value Vav is obtained by averaging in time the output Q of the flip-flop 2 by the average value detector 3 for the duration (=1/|fdata-fvco|) corresponding to the difference between the frequency (fdata) of the data signal and the frequency (fvco) of the clock CLK.

Fig. 4 is a timing chart at deterioration of the S/N (signal to noise) ratio of a data signal, according to an embodiment of the present invention. The S/N ratio deterioration of the data signal appears as an increase in jitter at a cross point of a data signal. In such a case, the falling of the clock CLK of the voltage controlled oscillator is synchronized with the data signal. However, the flip-flop 2 samples the low level VL of the CLK 90 with the probability that the cross point of the data signal distributes in the time axis direction. In other words, the distribution of cross points due to jitters, as shown in Fig.4, resembles nearly a normal distribution (mean µ and dispersion σ) (when the rising of the clock CLK is synchronized with the data signal, the center (mean µ)of a normal distribution matches the timing c with which the clock CLK rises. When jitters at a cross point of a data signal exceeds the time width of a high level duration of the clock CLK 90, with the timing c as the reference, the flip-flop 2 samples the clock CLK 90 in a low level.

As shown by the cross point distribution due to jitters in Fig. 4, the probability that the flip-flop 2 samples the clock CLK 90 in a low level is small. For that reason, the output Vav of the average value detector 3 becomes a value, (VH+VL)/2<Vav<VH, close to a high level VH rather than an intermediate value. However, because there is the probability that the jitter of a cross point in a data signal exceeds the time width of a high level duration of the clock CLK 90, with the timing c as the reference, (or the probability that the low level of the clock CLK 90 is sampled), the average value Vav is not VH.

The reference voltage (threshold value) Vref of the comparator 4 is set between (VH+VL)/2 and VH. With the average value less than the reference voltage, out-of-clock synchronization is detected so that the alarm can be issued. That is, the reference voltage Vref of the comparator 4 is set between the outputs VacN and VH of the average value detector 3 at the time the S/N ratio of a data signal is deteriorated. Thus, the comparator 4 can detect the deteriorated S/N ratio of a received data signal and the predetermined transmission line quality not accomplished, thus issuing the alarm.

In this embodiment, the flip-flop 2 samples the clock CLK 90, obtained by delaying the clock of the voltage controlled oscillator by 90 degrees by the delay circuit 1, at a changing point (in falling or in rising) of the data signal. Hence, since the jitter width of the data signal is within the duration for which a clock is in a high level, the flip-flop 2 can certainly produce a high level VH. The comparator 4, which receives the average value Vav output from the average value detector 3, does not issue the alarm. That is, if the jitter occurs within a predetermined range, the average value detector 3 outputs its output of a reference voltage Vref or more. Hence, since the comparator 4 does not issue the alarm due to out-of-synchronization, an erroneous operation can be avoided due to the presence of a jitter of a data signal.

In the frequency synchronization, the timing of the falling of the clock CLK (a transition edge changing from a high level to a low level) matches the cross point of the data signal. However, the timing of the rising of the clock CLK may match the cross point of the data signal. Now such an embodiment will be explained below.

At a normal time or at the time of frequency synchronization, the flip-flop 2 captures a low level VL of CLK 90 at the time of transition of a data signal and outputs it from its output Q. In other words, the high level VH is replaced with the low level VL. The average value detector 3 outputs its output Vav (=VL).

In the case of out-of-synchronization, the output of the average value detector 3 is Vav = (VH+VL)/2.

Deterioration of the S/N ratio of the data signal appears as an increase in jitter at a cross point of the data signal. In such a case, the rising of the output clock CLK of the voltage controlled oscillator is synchronized with the data signal. However, the flip-flop 2 acquires the clock CLK of a high level VH, with the probability depending on the distribution in the time axis direction at a cross point. When the jitter of the data signal is out of the time width of the low-level duration of the clock CLK 90, the flip-flop 2 captures the high level VH of the clock CLK 90. However, the probability of capturing the high level is small. For this reason, the output Vav (average value) of the average value detector 3 is (VH+VL)/2 > Vav > VL.

Since the reference voltage Vref of the comparator 4 is set between (VH+VL)/2 and VL, out-of-clock synchronization due to jitter components is detected so that an alarm can be issued. That is, the reference voltage Vref of the comparator 4 is set between outputs VavN and VL of the average value detector 3 at the time of deterioration of the S/N ratio of a data signal. Thus, when the average value exceeds the reference voltage, the comparator 4 detects deterioration of the S/N ratio of the received data signal and the predetermined transmission line quality in an unaccomplished state, thus issuing the alarm.

In addition to an optical receiver, the out-of-sync detector mentioned above is suitably applied to a receiver which has a clock reproduction circuit (PLL) that creates clocks synchronized with the received data signal transmitted along the transmission line.

As described above, according to the present invention, the flip-flop samples clocks obtained by delaying clocks from the signal oscillator delayed by a predetermined phase amount, at data signal changing points (that is, in rising or in falling) and monitors an average value of outputs of the flip-flop. Thus, the present invention has the advantage in that out-of-synchronization of clocks can be detected.

Moreover, according to the present invention, the out-of-sync detector can detect deterioration of the S/N ratio of a received data signal as well as a predetermined transmission line quality in an unaccomplished state and can produce the alarm.

## Claims

1. An out-of-sync detector that detects whether or not two signals are synchronized with each other, comprising:
a first circuit for delaying one of said two signals by a predetermined phase and outputting a delayed signal;
a second circuit for sampling outputs of said first circuit in sync with a transition of the other of said two signals;
a third circuit for outputting an average value of an output from said second circuit; and
a fourth circuit for comparing said average value with a predetermined threshold value and detecting the presence or absence of out-of-synchronization.

2. An out-of-sync detector, which receives a first signal and a second signal of which the phase and frequency are synchronized with those of said first signal and detects whether or not said first signal is synchronized with said second signal, comprising:
a delay circuit for delaying said second signal by a predetermined phase;
a sequential logical circuit for sampling said second signal delayed by said delay circuit, in sync with a falling or rising transition of said second signal;
an average value detector for detecting an average value of an output of said sequential logical circuit; and
a comparator for comparing in amplitude the average value from said average value detector with a predetermined threshold value and then outputting a comparison result as a signal indicating the presence or absence of out-of-synchronization.

3. The out-of-sync detector defined in Claim 2, wherein said second signal comprises an oscillation output signal of a signal oscillator, said signal oscillator receiving a control signal having a value corresponding to a difference in frequency and phase between said first signal and said second signal and varying its oscillation frequency under said control signal.

4. The out-of-sync detector defined in Claim 2, wherein said delay circuit delays said second signal by a phase component corresponding to a half of the pulse width of said second signal.

5. An out-of-sync detector comprising:
a delay circuit for delaying a clock from a signal oscillator by a predetermined phase, the oscillation frequency of said signal oscillator being varied by a control signal;
a flip-flop for sampling a clock delayed by the said delay circuit, at a falling edge or rising edge of a data signal;
an average value detector for detecting and outputting an average of an output from said flip-flop; and
a comparator for comparing said average value with a predetermined threshold value and issuing an alarm at the time of detecting out-of-synchronization.

6. The out-of-sync detector defined in Claim 5 wherein said signal oscillator comprises a voltage controlled oscillator or a current controlled oscillator, said voltage controlled oscillator or said current controlled oscillator receiving a control signal in accordance with a difference in frequency and in phase output from said phase frequency comparator, oscillating at an oscillation frequency in accordance with said control signal, and thus outputting an oscillation clock, said phase frequency comparator receiving said received data and said clock.

7. The out-of-sync detector defined claim 5, wherein said delay circuit delays said clock by a phase amount corresponding to a half of a pulse width of said clock.

8. The out-of-sync detector defined in Claim 6, wherein said delay circuit outputs a clock of which the frequency or phase is delayed by 90 degrees.

9. The out-of-sync detector defined in Claim 5, wherein said average value output from said average value detector has a first value when said data signal is synchronized with said clock in frequency and in phase, with said clock falling in sync with transition of said data signal; and wherein said comparator detects an increase in jitter of said data signal and produces said alarm when said average value is smaller than a predetermined threshold value, said predetermined threshold value being set between said first value and an intermediate value, said intermediate value being set between said first value and a second value smaller than said first value.

10. The out-of-sync detector defined in Claim 5, wherein said average value output from said average value detector has a first value when said data signal is synchronized with said clock in frequency and in phase, with said clock rising in sync with transition of said data signal; and wherein said comparator issues said alarm when said average value is equal to or smaller than a threshold value, said threshold value being set to an intermediate value between said first value and a second value smaller than said first value.

11. The out-of-sync detector defined in Claim 5, wherein said average value output from said average value detector has a second value when said data signal is synchronized with said clock pulse in frequency and in phase, said clock pulse rising in sync with transition of said data signal; and wherein said comparator detects an increase in jitter of said data signal when said average value is larger than a predetermined threshold value and then issues said alarm, said predetermined threshold value being set between said second value and an intermediate value, said intermediate value being between said second value and a first value larger than said second value.

12. The out-of-sync detector defined in Claim 5, wherein said average value output from said average value detector has a second value when said data signal is synchronized with said clock in frequency and in phase, with said clock rising in sync with transition of said data signal; and wherein said comparator issues said alarm when said average value is equal to or larger than an intermediate value, said intermediate value being set between said second value and a first value larger than said second value.

13. The out-of-sync detector defined in Claim 5, wherein said average value detector creates a dc voltage corresponding to an average value obtained by averaging an output value of said flip-flop with respect to time for a predetermined time period, and then outputting said dc voltage as said average value.

14. The out-of-sync detector defined in Claim 5, wherein said average value detector outputs as said average value a dc voltage between a first value and a second value, said dc voltage representing a ratio at which the sum of time widths occupies for a predetermined period, each of said time widths in which an output of said flip-flop has a first value or a second value.

15. A receiver comprising:
a first circuit for delaying one of said two signals by a predetermined phase and outputting a delayed signal;
a second circuit for sampling outputs of said first circuit in sync with a transition of the other of said two signals;
a third circuit for outputting an average value of an output from said second circuit; and
a fourth circuit for comparing said average value with a predetermined threshold value and detecting the presence or absence of out-of-synchronization.

16. A receiver comprising:
a receiving circuit for receiving a first signal and a second signal of which the phase and frequency are synchronized with those of said first signal;
a delay circuit for delaying said second signal by a predetermined phase;
a sequential logical circuit for sampling said second signal delayed by said delay circuit, in sync with a falling or rising transition of said second signal;
an average value detector for detecting an average value of an output of said sequential logical circuit; and
a comparator for comparing in amplitude the average value from said average value detector with a predetermined threshold value and then outputting a comparison result as a signal indicating the presence or absence of out-of-synchronization.

17. The receiver defined in Claim 16, wherein said second signal comprises an oscillation output signal of a signal oscillator, said signal oscillator receiving a control signal having a value corresponding to a difference in frequency and phase between said first signal and said second signal and varying its oscillation frequency under said control signal.

18. The receiver defined in Claim 16, wherein said delay circuit delays said second signal by a phase component corresponding to a half of the pulse width of said second signal.

19. A receiver comprising:
a delay circuit for delaying a clock from a signal oscillator by a predetermined phase, the oscillation frequency of said signal oscillator being varied by a control signal;
a flip-flop for sampling a clock delayed by the said delay circuit, at a falling edge or rising edge of a data signal;
an average value detector for detecting and outputting an average of an output from said flip-flop; and
a comparator for comparing said average value with a predetermined threshold value and issuing an alarm at the time of detecting out-of-synchronization.

20. The receiver defined in Claim 19 wherein said signal oscillator comprises a voltage controlled oscillator or a current controlled oscillator, said voltage controlled oscillator or said current controlled oscillator receiving a control signal in accordance with a difference in frequency and in phase output from said phase frequency comparator, oscillating at an oscillation frequency in accordance with said control signal, and thus outputting an oscillation clock, said phase frequency comparator receiving said received data and said clock.

21. The receiver defined claim 19, wherein said delay circuit delays said clock by a phase amount corresponding to a half of a pulse width of said clock.

22. The receiver defined in Claim 20, wherein said delay circuit outputs a clock of which the frequency or phase is delayed by 90 degrees.

23. The receiver defined in Claim 19, wherein said average value output from said average value detector has a first value when said data signal is synchronized with said clock in frequency and in phase, with said clock falling in sync with transition of said data signal; and wherein said comparator detects an increase in jitter of said data signal and produces said alarm when said average value is smaller than a predetermined threshold value, said predetermined threshold value being set between said first value and an intermediate value, said intermediate value being set between said first value and a second value smaller than said first value.

24. The receiver defined in Claim 19, wherein said average value output from said average value detector has a first value when said data signal is synchronized with said clock in frequency and in phase, with said clock rising in sync with transition of said data signal; and wherein said comparator issues said alarm when said average value is equal to or smaller than a threshold value, said threshold value being set to an intermediate value between said first value and a second value smaller than said first value.

25. The receiver defined in Claim 19, wherein said average value output from said average value detector has a second value when said data signal is synchronized with said clock pulse in frequency and in phase, said clock pulse rising in sync with transition of said data signal; and wherein said comparator detects an increase in jitter of said data signal when said average value is larger than a predetermined threshold value and then issues said alarm, said predetermined threshold value being set between said second value and an intermediate value, said intermediate value being between said second value and a first value larger than said second value.

26. The receiver defined in Claim 19, wherein said average value output from said average value detector has a second value when said data signal is synchronized with said clock in frequency and in phase, with said clock rising in sync with transition of said data signal; and wherein said comparator issues said alarm when said average value is equal to or larger than an intermediate value, said intermediate value being set between said second value and a first value larger than said second value.

27. The receiver defined in Claim 19, wherein said average value detector creates a dc voltage corresponding to an average value obtained by averaging an output value of said flip-flop with respect to time for a predetermined time period, and then outputting said dc voltage as said average value.

28. The receiver defined in Claim 19, wherein said average value detector outputs as said average value a dc voltage between a first value and a second value, said dc voltage representing a ratio at which the sum of time widths occupies for a predetermined period, each of said time widths in which an output of said flip-flop has a first value or a second value.

29. An optical receiver comprising:
a delay circuit for delaying a clock from a signal oscillator by a predetermined phase, the oscillation frequency of said signal oscillator being varied by a control signal;
a flip-flop for sampling a clock delayed by the said delay circuit, at a falling edge or rising edge of a data signal detected by an optical detector;
an average value detector for detecting and outputting an average of an output from said flip-flop; and
a comparator for comparing said average value with a predetermined threshold value and issuing an alarm at the time of detecting out-of-synchronization.

30. The optical receiver defined in Claim 29 wherein said signal oscillator comprises a voltage controlled oscillator or a current controlled oscillator, said voltage controlled oscillator or said current controlled oscillator receiving a control signal in accordance with a difference in frequency and in phase output from said phase frequency comparator, oscillating at an oscillation frequency in accordance with said control signal, and thus outputting an oscillation clock, said phase frequency comparator receiving said received data and said clock.

31. The optical receiver defined claim 29, wherein said delay circuit delays said clock by a phase amount corresponding to a half of a pulse width of said clock.

32. The optical receiver defined in Claim 30, wherein said delay circuit outputs a clock of which the frequency or phase is delayed by 90 degrees.

33. The optical receiver defined in Claim 29, wherein said average value output from said average value detector has a first value when said data signal is synchronized with said clock in frequency and in phase, with said clock falling in sync with transition of said data signal; and wherein said comparator detects an increase in jitter of said data signal and produces said alarm when said average value is smaller than a predetermined threshold value, said predetermined threshold value being set between said first value and an intermediate value, said intermediate value being set between said first value and a second value smaller than said first value.

34. The optical receiver defined in Claim 29, wherein said average value output from said average value detector has a first value when said data signal is synchronized with said clock in frequency and in phase, with said clock rising in sync with transition of said data signal; and wherein said comparator issues said alarm when said average value is equal to or smaller than a threshold value, said threshold value being set to an intermediate value between said first value and a second value smaller than said first value.

35. The optical receiver defined in Claim 29, wherein said average value output from said average value detector has a second value when said data signal is synchronized with said clock pulse in frequency and in phase, said clock pulse rising in sync with transition of said data signal; and wherein said comparator detects an increase in jitter of said data signal when said average value is larger than a predetermined threshold value and then issues said alarm, said predetermined threshold value being set between said second value and an intermediate value, said intermediate value being between said second value and a first value larger than said second value.

36. The out-of-sync detector defined in Claim 29, wherein said average value output from said average value detector has a second value when said data signal is synchronized with said clock in frequency and in phase, with said clock rising in sync with transition of said data signal; and wherein said comparator issues said alarm when said average value is equal to or larger than an intermediate value, said intermediate value being set between said second value and a first value larger than said second value.

37. The optical receiver defined in Claim 29, wherein said average value detector creates a dc voltage corresponding to an average value obtained by averaging an output value of said flip-flop with respect to time for a predetermined time period, and then outputting said dc voltage as said average value.

38. The optical receiver defined in Claim 29, wherein said average value detector outputs as said average value a dc voltage between a first value and a second value, said dc voltage representing a ratio at which the sum of time widths occupies for a predetermined period, each of said time widths in which an output of said flip-flop has a first value or a second value.
